# EUROPEAN PATENT SPECIFICATION

(11) **EP 1 510 991 B1**
(45) Date of publication and mention of the grant of the patent: **04.04.2007**
(21) Application number: 04019228.8
(22) Date of filing: 12.08.2004
(51) Int. Cl.: G09F 3/02, G09F 3/10

(54) **Label and ventilation housing using the same**
Etikett und Klimaanlagegehäuse
Etiquette et boîtier de climatisation utilisant cette étiquette

(30) Priority: 26.08.2003 JP 2003301616
(43) Date of publication of application: 02.03.2005
(73) Proprietor: NITTO DENKO CORPORATION, Osaka (JP)
(72) Inventor: Nishii, Hiroyuki, Ibaraki-shi Osaka (JP); Mashiko, Hiroaki, Ibaraki-shi Osaka (JP); Ikeyama, Yoshiki, Ibaraki-shi Osaka (JP)
(74) Representative: Grünecker, Kinkeldey, Stockmair & Schwanhäusser Anwaltssozietät

(56) References cited:
- WO-A-86/03767
- DE-A1- 19 653 890

## Description

### FIELD OF THE INVENTION

The present invention relates to a label for application to a housing of appliances, etc. The present invention further relates to a ventilation housing to which the label has been applied.

### BACKGROUND ART

There are cases where the housings of appliances such as automotive electrical equipments, e.g., ECUs (electronic control units), lamps, motors, various sensors, and pressure switches, cell phones, cameras, electric razors, electric toothbrushes, and outdoor lamps have labels applied thereto which bear information about the appliance housings. For example, since an exceedingly large number of parts are handled in producing motor vehicles, each part has a label applied thereto which bears a code (e.g., a bar code or two-dimensional code) containing information about the type number, kind of the car in which the part is to be used, specification of the car, etc. The parts are managed based on such information (see, for example, JP-A-2002-40943).

On the other hand, those appliance housings have a vent filter attached thereto. These vent filters perform various functions according to the kinds of the housings. For example, the vent filter of an appliance housing not only prevents water or dust particles from coming into the housing, but also functions to transmit sound, release a gas generated in the housing, and diminish pressure changes in the housing -due to temperature fluctuations.

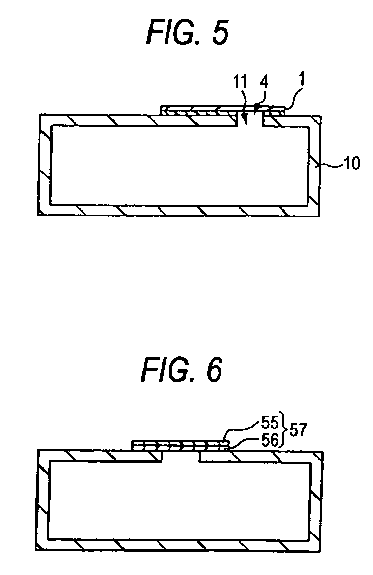

Fig. 6 shows an example of a housing having a bent filter (ventilation housing). In the example shown in Fig. 6, a vent filter 57 has a structure comprising an air-permeable film 55 and laminated thereto a reinforcement 56 having air permeability. The air-permeable film 55 comprises, for example, a porous polytetrafluoroethylene (PTFE), and the reinforcement 56 comprises, for example, a nonwoven fabric (see, for example, JP-A-2001-168543).

However, the production of ventilation housings heretofore in use has been costly because the production process includes the steps of preparing a label and a vent filter as separate members and attaching these to a housing.

### SUMMARY OF THE INVENTION

The present invention has been made in view of the above.

One object of the present invention is to provide a label for application to a housing of appliances, etc.

Another object of the present invention is to provide a ventilation housing to which the label has been applied.

The label according to the present invention comprises an ink-reoeiving layer and a pressure-sensitive adhesive layer for applying the ink-receiving layer to an adherend, wherein the ink-receiving layer is an air-permeable porous material comprising at least one resin selected from polytetrafluoroethylenes (PTFE) and polyolefins, and the label has, formed in at least the pressure-sensitive adhesive layer, an air passage hole which extends from one to the other side of the pressure-sensitive adhesive layer in the thickness direction and enables a gas which has permeated the ink-receiving layer to pass therethrough.

The ventilation housing according to the present invention comprises a housing having an opening and the label applied to the housing such that the air passage hole is connected to the opening of the housing.

According to the present invention, a label having a vent filter function and a ventilation housing having a reduced cost can be provided.

### BRIEF DESCRIPTION OF THE DRAWINGS

Fig. 1A is a slant view showing one embodiment of the label of the present invention on which information has been printed.
Fig. 1B is a sectional view taken on the line I-I' of Fig. 1A.
Fig. 2 is a sectional view showing another embodiment of the label of the present invention.
Figs. 3A and 3B are slant views showing examples of a label-holding material obtained by applying labels of the constitution shown in Fig. 1 to a releasable sheet material.
Fig. 4 is a sectional view showing still another embodiment of the label of the present invention.
Fig. 5 is a sectional view showing one embodiment of the ventilation housing of the present invention.
Fig. 6 is a sectional view showing an example of a conventional ventilation housing.

In the drawings:
- 1: label
- 2: ink-receiving layer
- 3: pressure-sensitive adhesive layer
- 4: air passage hole
- 6: air-permeable support layer
- 7: air-impermeable reinforcing layer
- 10: housing
- 11: opening
- 12: sheet material
- 13: surface coat layer

### DETAILED DESCRIPTION OF THE INVENTION

One embodiment of the label of the present invention will be explained by reference to the drawings.

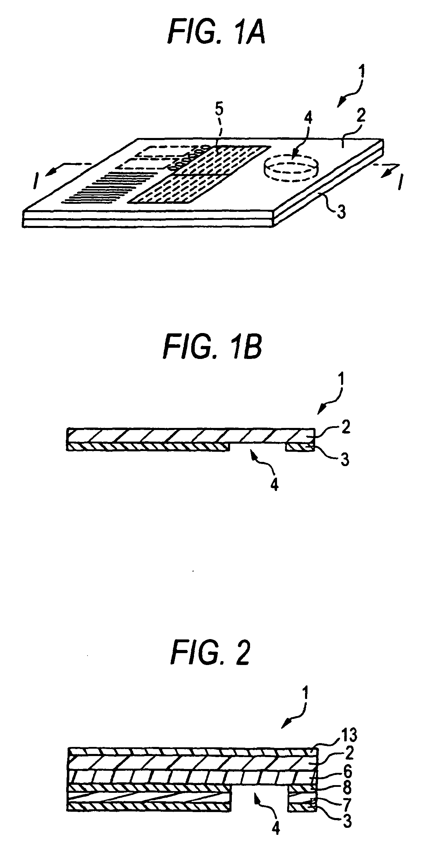

Fig. 1 shows a label 1 as an embodiment, which is a label comprising an ink-receiving layer 2 and a pressure-sensitive adhesive layer 3. The ink-receiving layer 2 is an air-permeable porous material comprising at least one resin selected form PTFE and polyolefins. This label has, formed in at least the pressure-sensitive adhesive layer 3, an air passage hole 4 which extends from one to the other side of the pressure-sensitive adhesive layer 3 in the thickness direction and enables a gas which has penetrated the ink-receiving layer 2 to pass therethrough. Because of this constitution, when the label 1 bearing printed information is applied to a housing such that the air passage hole 4 is connected to the opening of the housing, not only the information can be imparted to the housing but also ventilation of the housing can be secured while inhibiting water or dust particles from coming into the housing.

Since the label 1 also functions as a vent filter as described above, there is no need of separately producing a label and a vent filter in producing a ventilation housing, and the operation for attaching a label and a vent filter to a housing can be simplified. As a result, the cost of the ventilation housing can be reduced.

When information is imparted to the ink-receiving layer 2 by printing with, e.g., an ink, the ink infiltrates into pores and is fixed. The information printed with an ink hence has excellent wearing resistance. The at least one resin selected from PTFE and polyolefins can be easily made to have porosity with satisfactory precision. The resin can hence realize an ink-receiving layer 2 which has pores having a regulated pore diameter so as to prevent ink separation and which has excellent air permeation stability.

In particular, PTFE can be easily made microporous and can hence realize an ink-receiving layer 2 (porous PTFE) which, even when small in area, has high air permeability and is highly effective in inhibiting water or dust particles from coming into the housing. PTFE is also preferred in its high heat resistance.

On the other hand, polyolefins are preferred in that they are inexpensive and easy to recycle. Examples of monomers for the polyolefins include ethylene, propylene, 4-methylpentene-1, and 1-butene. A polyolefin obtained by the homopolymerization of one of such monomers or by copolymerizing two or more of these can be used in the ink-receiving layer 2. The ink-receiving layer 2 may be made of a blend of two or more of such polyolefins, or may have a multilayer structure in which each layer is made of one resin selected from those polyolefins. Especially preferred of those polyolefins is ultrahigh-molecular polyethylene having a viscosity-average molecular weight of 300,000-10,000,000, preferably 500,000-9,000,000, which has high strength and is excellent in handleability and heat resistance.

The average pore diameter of the ink-receiving layer 2 is generally 100 µm or smaller, and preferably 0.5-60 µm, because too large pore diameters thereof result in a decrease in film strength and a decrease in waterproofing and dust-proofing properties. Further, from the standpoints of clearness of printed information and ink infiltration, the average pore diameter of the ink-receiving layer 2 preferably is within that range.

The thickness of the ink-receiving layer 2 is generally preferably 5 µm or larger because too small thicknesses thereof result in reduced strength and hence in difficulties in processing.

That side of the ink-receiving layer 2, opposite the pressure-sensitive adhesive layer 3 is preferably subjected to any of various treatments, such as corona discharge treatment or chemical etching treatment, so as to enhance ink infiltration.

It is preferred that information 5 be printed on the ink-receiving layer 2 in an area located outside the region to be permeated by a gas which has passed through the air passage hole 4 in the ink-receiving layer 2. This is intended to secure sufficient air permeability in the region to be permeated by a gas which has passed through the air passage hole 4 in the ink-receiving layer 2.

The contents of the information 5 are not particularly limited, and may be any of a bar code or two-dimensional code which is coded information about, e.g., article name, lot number, and type number, characters, figures, and the like.

Techniques for printing on the label 1 are not particularly limited. Examples the printing technique include thermal transfer printing, ink-jet printing, and laser printing. Thermal transfer inks for thermal transfer printing can use, for example, commercial thermal-transfer ink sheets of the resin type or wax type. An ink-receiving layer 2 on which information has been printed by any of these printing techniques may be heated with, e.g., a heated roll to thereby accelerate ink infiltration into the ink-receiving layer 2.

The air permeability of the region to be permeated by a gas which has passed through the air passage hole 4 in the ink-receiving layer 2 is determined after the area of the opening of the housing (area of the plane perpendicular to the gas permeation direction), kind of the housing to which the label is to be attached, etc. are taken into account. In general, however, the air permeability thereof is preferably 0.1-300 sec/100 ml. In the present invention, values of air permeability (Gurley air permeability) are found values obtained through a measurement in accordance with JIS P 8117.

The ink-receiving layer 2 can be produced by, for example, the following manner.

Where the ink-receiving layer 2 is porous PTFE layer, the first step is to preform a pasty mixture obtained by adding a liquid lubricant to a fine PTFE powder. The liquid lubricant is not particularly limited as long as it can wet the surface of the fine PTFE powder and be removed by extraction or heating. For example, hydrocarbons such as naphtha and white oil can be used. The amount of the liquid lubricant added is desirably about 5-50 parts by weight per 100 parts by weight of the fine PTFE powder. The preforming is conducted at such a pressure that the liquid lubricant is not squeezed out. Subsequently, the preform is formed into a sheet by extrusion and/or rolling. The sheet-form molding thus obtained is stretched at least uniaxially, whereby a porous PTFE sheet can be obtained. It is preferred to conduct the stretching after the liquid lubricant is removed. Conditions for the stretching can be suitably selected. Usually, the conditions include a temperature of 20-320°C and a stretch ratio of 2-3'0 kr <ach <f the machine and transverse directions. The porous PTFE sheet obtained through stretching may be burned by heating to a temperature not lower than the melting point of the PTFE, whereby the strength of the porous PTFE sheet can be heightened.

Where the ink-receiving layer 2 is a porous layer comprising a polyolefin, this ink-receiving layer 2 can be produced by, for example, (1) a method which comprises molding a resin by melt extrusion and subjecting the molded resin to low-temperature stretching and then to high-temperature stretching (dry film-forming method), (2) a method which comprises mixing a resin with an extractable material, subjecting the mixture to treatments such as molding and stretching, and removing the extractable material by extraction with a solvent or the like (wet film-forming method), or (3) a method which comprises fusion-bonding particles of a resin to one another with pressing to form a porous block and cutting the block into a desired shape.

The material of the pressure-sensitive adhesive layer 3 can use a hot-melt adhesive, a pressure-sensitive adhesive, or the like. Examples of the hot-melt adhesive that can be used include the polyester, olefin, polyurethane, polyamide, and acrylic types. Examples of the pressure-sensitive adhesive that can be used include the acrylic, silicone, rubber-based, polyurethane, and vinyl ether types. These adhesives may be used alone or in combination of two or more thereof

The pressure-sensitive adhesive layer 3 can be formed by, for example, laminating with heating, extrusion coating, or another coating technique. Where the pressure-sensitive adhesive layer 3 is formed from a pressure-sensitive adhesive, the pressure-sensitive adhesive may directly be applied to the ink-receiving layer 2 to form the pressure-sensitive adhesive layer 3. Alternatively, the pressure-sensitive adhesive may be applied to a release sheet to form a pressure-sensitive adhesive layer and this adhesive layer may be applied to the ink-receiving layer 2 to form the pressure-sensitive adhesive layer 3.

As shown in Fig. 2, the label 1 preferably includes an air-permeable support layer 6 disposed between the ink-receiving layer 2 and the pressure-sensitive adhesive layer 3. The disposition of the air-permeable support layer 6 is effective in preventing the region to be permeated by a gas which has passed through the ink-receiving layer 2, especially through the air passage hole 4 of the ink-receiving layer 2, from damaging. The support layer 6 further functions to enhance the handleability of the label 1. When the printing label thus includes the air-permeable support layer 6, the layered structure consisting of the ink-receiving layer 2 and the air-permeable support layer 6 preferably has an air permeability of 0.1-300 sec/100 ml in the region to be permeated by a gas which has passed through the air passage hole 4.

The air-permeable support layer 6 is not particularly limited in material, structure, and form. However, a porous material having higher air permeability than the ink-receiving layer 2 can, for example, be used as the air-permeable support layer 6. Examples of the porous material include porous ultrahigh-molecular polyethylene, nonwoven fabrics, woven fabrics, nets, meshes, sponges, foams, porous metals, and metallic meshes. In particular, nonwoven fabrics are preferred because they are satisfactory in workability, fusion bondability, etc.

Bonding between the ink-receiving layer 2 and the air-permeable support layer 6 can be conducted by, for example, a technique such as ultrasonic fusion bonding, vibrational fusion bonding, adhesive laminating with a pressure-sensitive adhesive, or thermal laminating. For example, in the case of bonding by thermal laminating, part of the air-permeable support layer 6 is melted by heating to bond the ink-receiving layer 2 to the air-permeable support layer 6. It is also possible to interpose a fusion-bonding agent such as a hot-melt powder to conduct bonding.

The edges of the air-permeable support layer 6 are preferably made nonporous. By making the edges of the air-permeable support layer 6 nonporous by fusion-bonding or another technique, dust particles or water can be inhibited from coming into the label through the edges of the air-permeable support layer 6. The dust-proofing and waterproofing properties of the label can hence be enhanced.

The label 1 preferably is one which includes an air-impermeable reinforcing layer 7 disposed between the ink-receiving layer 2 and the pressure-sensitive adhesive layer 3 and in which the air passage hole 4 extends from one to the other side of the air-impermeable reinforcing layer 7, as shown in Fig. 2. The inclusion of the air-impermeable reinforcing layer 7 can enhance the strength and handleability of the label 1.

The air-impermeable reinforcing layer 7 is not particularly limited in material, structure, and form. However, a resin film, metal foil, or the like can, for example, be used as the air-impermeable reinforcing layer 7. Examples of the material of the resin film that can be used include polyolefins, vinyl resins, polyesters, polyurethanes, polyamides, and acrylic resins.

Methods of bonding the air-impermeable reinforcing layer 7 to a layer (the air-permeable support layer 6 in Fig. 2) adjacent to the air-impermeable reinforcing layer 7 include bonding with an adhesive (pressure-sensitive adhesive), e.g., a pressure-sensitive adhesive layer 8 as shown in Fig. 2, thermal fusion bonding, ultrasonic fusion bonding, and vibrational fusion bonding. It is also possible to interpose a fusion-bonding agent such as a hot-melt powder to bond the air-impermeable reinforcing layer 7 to a layer adjacent to the air-impermeable reinforcing layer 7. Use of these methods is effective in attaining a cost reduction because the bonding of the air-impermeable reinforcing layer 7 to a layer adjacent to the air-impermeable reinforcing layer 7 can be easily conducted in a short period of time.

The label 1 preferably includes a surface coat layer 13 formed on the ink-receiving layer 2 on the side opposite the pressure-sensitive adhesive layer 3, as shown in Fig. 2. For example, a surface coat layer 13 containing inorganic particles, such as silica, titania or alumina, is formed, whereby ink fixability can be improved. These inorganic powdery materials may be used alone or in combination of two or more thereof.

The surface coat layer 13 may be one intended to give a color or improve heat resistance. When the surface coat layer 13 contains a pigment having a high color contrast with the ink to be used for printing, e.g., when the ink to be used for printing is black and the layer 13 contains a white pigment, then information can be clearly printed. When the surface coat layer 13 contains an antioxidant, the heat resistance of the label can be improved.

The surface coat layer 13 can be formed by preparing a coating fluid comprising an appropriate solvent and, dissolved or dispersed therein, an organic binder and at least one member selected from the inorganic powdery materials, pigments, and antioxidants, applying the coating fluid to the ink-receiving layer 2 on the side opposite the pressure-sensitive adhesive layer 3 by, e.g., gravure coating, and thermally curing the coating fluid applied. The organic binder is not particularly limited, and examples thereof include polyurethanes, polyesters, epoxy resins, and acrylic resins. It is preferred that the surface coat layer 13 be formed in an area located outside the region to be permeated by a gas which has passed through the air passage hole 4 in the ink-receiving layer 2, so as to secure sufficient air permeability in that region.

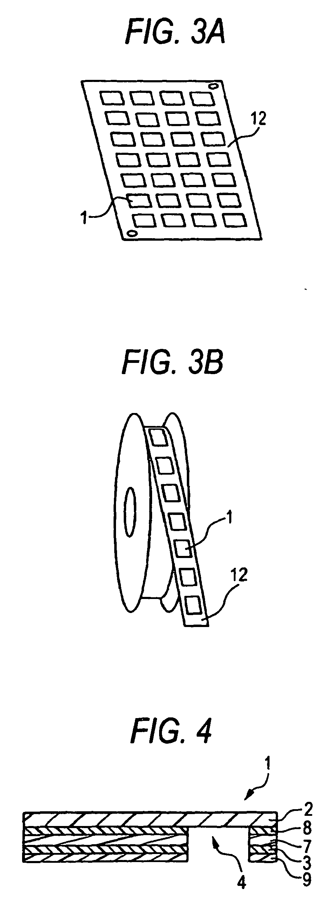

The label 1 preferably is applied to a releasable sheet material 12 as shown in Fig. 3A and stored, transported, or otherwise processed in this state. This is because the label-holding material obtained by applying two or more labels 1 to a releasable sheet material 12 is easy to handle, shows improved suitability for pickup when labels 1 are applied to housings with an automatic labeling machine, and thereby facilitates automation of labeling. The sheet material 12 may be in a strip form and the sheet material 12 to which two or more labels 1 have been applied may have been wound into a roll, as shown in Fig. 3B.

Fig. 5 shows an embodiment of a ventilation housing to which the label 1 shown in Fig. 1 has been applied. As shown in Fig. 5, this ventilation housing shown as an embodiment comprises a label 1 on which information has been printed and a housing 10 having an opening 11. The label 1 has been applied to the housing 10 so that the air passage hole 4 in the label 1 is connected to the opening 11 of the housing 10. Because of this, not only information about, e.g., article name can be displayed on the housing 10, but also ventilation of the housing can be secured while inhibiting the penetration of water or dust particles into the housing. The ventilation housing shown in Fig. 5 has one label 1 applied thereto. However, the number of labels 1 is not particularly limited, and two or more labels 1 may be applied to another or the same side of the housing 10.

The present invention will be explained below in more detail by reference to the following Examples, but it should be understood that the invention is not construed as limiting thereto.

The hydraulic test and dust-proof test conducted in the following Examples are as follows.

### Hydraulic Test

A ventilation housing was placed in a water-containing pressure vessel so that the label was located in the water at a depth of 5 cm. The ventilation housing in this state was allowed to stand for 5 minutes, and then visually examined for water penetration into the ventilation housing.

### Dust-Proof Test

200 g of test dust No. 8 (Kanto loam, JIS Z 8901) and a ventilation housing were introduced into a vessel having a capacity of 10 liters. This vessel was rotated at a speed of 10 rpm for 10 minutes. Thereafter, the ventilation housing was taken out of the vessel and then visually examined for dust penetration into the ventilation housing.

### EXAMPLE 1

The label 1 shown in Fig. 4 was produced in the following manner. First, two pressure-sensitive adhesive layers ("No. 500" manufactured by Nitto Denko Corp.) covered with release sheets were prepared. These pressure-sensitive adhesive layers were applied respectively to both main sides of a PTFE film (air-impermeable reinforcing layer; thickness: 50 µm) to obtain a multilayer structure. A through-hole having a diameter of 10 mm was formed in this multilayer structure by punching. Subsequently, the release sheet disposed on one side of the multilayer structure was stripped off and the PTFE film was laminated to a porous PTFE sheet (trade name: "Microtex (Temish) NTF 1131" manufactured by Nitto Denko Corp.; thickness: 80 µm; average pore diameter: 1 µm; Gurley air permeability: 3 sec/100 ml). This laminate was punched into a size of 40x60 mm to obtain a label 1 of the constitution shown in Fig. 4, which comprised an ink-receiving layer 2 consisting of the porous PTFE sheet, an air-impermeable reinforcing layer 7 consisting of the PTFE film, and a pressure-sensitive adhesive layer 3. In Fig. 4, numeral 9 denotes a release sheet and 8 denotes a pressure-sensitive adhesive layer which bonds the air-impermeable reinforcing layer 7 to the ink-receiving layer 2.

A given pattern (information) was printed on the ink-receiving layer 2 using a commercial thermal transfer printer and an ink sheet. The label 1 showed satisfactory printability.

On the other hand, poly(butylene terephthalate) ("CG7640" manufactured by Teijin Ltd.) was used to produce a housing 10 of the structure shown in Fig. 5 by injection molding. The opening 11 of the housing 10 obtained had a diameter of 8 mm.

The label 1 was applied to this housing 10 so that the air passage hole 4 was connected to the opening 11. Thus, a ventilation housing was obtained. The ventilation housing obtained was subjected to the hydraulic test and the dust-proof test. As a result, no penetration of water or dust into the ventilation housing occurred.

### EXAMPLE 2

A label was produced in the same manner as in Example 1, except that a porous ultrahigh-molecular polyethylene sheet ("Sunmap" manufactured by Nitto Denko Corp.; thickness: 200 µm; average pore diameter: 20 µm; Gurley air permeability: 0.5 sec/100 ml) was used as the ink-receiving layer. A pattern (information) was printed in the same manner as in Example 1. As a result, the label showed satisfactory printability. This label was applied to the housing produced in Example 1 to obtain a ventilation housing, which was subjected to the hydraulic test and the dust-proof test. As a result, no penetration of water or dust into the ventilation housing occurred.

### EXAMPLE 3

A porous PTFE sheet (trade name: "Microtex (Temish) NTF 1131" manufactured by Nitto Denko Corp.; thickness: 80 µm; average pore diameter: 1 µm) and a nonwoven polyester fabric (thickness: 200 pm) were prepared for use as an ink-receiving layer and an air-permeable support layer, respectively. A multilayer structure having a through-hole was prepared in the same manner as in Example 1. The release sheet disposed on one side of the multilayer structure was stripped off, and the nonwoven polyester fabric was laminated to the PTFE film (air-impermeable reinforcing layer). The porous PTFE sheet was press-bonded to the nonwoven polyester fabric with heating at 260°C. Except these, a label was produced in the same manner as in Example 1. The Gurley air permeability of a layered structure (thickness: 200 pm) consisting of the porous PTFE sheet and the nonwoven polyester fabric was examined and was found to be 10 sec/100 ml. A pattern (information) was printed in the same manner as in Example 1. As a result, the label showed satisfactory printability. This label was applied to the housing produced in Example 1 to obtain a ventilation housing, which was subjected to the hydraulic test and the dust-proof test. As a result, no penetration of water or dust into the ventilation housing occurred.

As described above, the present invention can provide a label having a vent filter function and a ventilation housing having a reduced cost. The label is hence suitable for application to the housings of appliances, etc.

It should further be apparent to those skilled in the art that various changes in form and detail of the invention as shown and described above may be made. It is intended that such changes be included within the spirit and scope of the claims appended hereto.

This application is based on Japanese Patent Application No. 2003-301616 filed August 26, 2003, the disclosure of which is incorporated herein by reference in its entirety.

## Claims

1. A label comprising an ink-receiving layer and a pressure-sensitive adhesive layer for applying the ink-receiving layer to an adherend, wherein the ink-receiving layer is an air-permeable porous material comprising at least one resin selected from polytetrafluoroethylene and polyolefins, and the label has, formed in at least the pressure-sensitive adhesive layer, an air passage hole which extends from one to the other side of the pressure-sensitive adhesive layer in the thickness direction and enables a gas which has permeated the ink-receiving layer to pass therethrough.

2. The label as claimed in claim 1, further comprising an air-permeable support layer disposed between the ink-receiving layer and the pressure-sensitive adhesive layer.

3. The label as claimed in claim 1, further comprising an air-impermeable reinforcing layer disposed between the ink-receiving layer and the pressure-sensitive adhesive layer, wherein the air passage hole extends from one to the other side of the air-impermeable reinforcing layer.

4. The label as claimed in claim 2, further comprising an air-impermeable reinforcing layer disposed between the ink-receiving layer and the pressure-sensitive adhesive layer, wherein the air passage hole extends from one to the other side of the air-impermeable reinforcing layer.

5. The label as claimed in claim 1, further comprising a surface coat layer formed on the ink-receiving layer on the side opposite the pressure-sensitive adhesive layer.

6. The label as claimed in claim 2, further comprising a surface coat layer formed on the ink-receiving layer on the side opposite the pressure-sensitive adhesive layer.

7. The label as claimed in claim 3, further comprising a surface coat layer formed on the ink-receiving layer on the side opposite the pressure-sensitive adhesive layer.

8. The label as claimed in claim 4, further comprising a surface coat layer formed on the ink-receiving layer on the side opposite the pressure-sensitive adhesive layer.

9. The label as claimed in claim 1, wherein the polyolefins comprise ultrahigh-molecular polyethylene.

10. The label as claimed in claim 1, wherein the ink-receiving layer bears information printed in an area located outside the region to be permeated by a gas which has passed through the air passage hole in the ink-receiving layer.

11. A ventilation housing comprising a housing having an opening and a label comprising an ink-receiving layer and a pressure-sensitive adhesive layer for applying the ink-receiving layer to an adherend, wherein the ink-receiving layer is an air-permeable porous material comprising at least one resin selected from polytetrafluoroethylene and polyolefins, and the label has, formed in at least the pressure-sensitive adhesive layer, an air passage hole which extends from one to the other side of the pressure-sensitive adhesive layer in the thickness direction and enables a gas which has permeated the ink-receiving layer to pass therethrough, the label being applied to the housing such that the air passage hole is connected to the opening of the housing.

## Patentansprüche

1. Etikett, das eine Tintenaufnahmeschicht und eine druckempfindliche Klebeschicht zum Aufbringen der Tintenaufnahmeschicht auf einen Träger umfasst, wobei die Tintenaufnahmeschicht ein luftdurchlässiges poröses Material ist, das wenigstens ein Harz umfasst, das aus Polytetrafluorethylen und Polyolefinen ausgewählt wird, und wenigstens in der druckempfindlichen Klebeschicht des Etiketts ein Luftdurchlassloch ausgebildet ist, das sich von einer zur anderen Seite der druckempfindlichen Klebeschicht in der Dickenrichtung erstreckt und ein Gas, das die Tintenaufnahmeschicht durchdrungen hat, hindurchtreten lässt.

2. Etikett nach Anspruch 1, das des Weiteren eine luftdurchlässige Trägerschicht umfasst, die zwischen der Tintenaufnahmeschicht und der druckempfindlichen Klebeschicht angeordnet ist.

3. Etikett nach Anspruch 1, das des Weiteren eine luftundurchlässige Verstärkungsschicht umfasst, die zwischen der Tintenaufnahmeschicht und der druckempfindlichen Klebeschicht angeordnet ist, wobei sich das Luftdurchlassloch von einer zur anderen Seite der luftundurchlässigen Verstärkungsschicht erstreckt.

4. Etikett nach Anspruch 2, das des Weiteren eine luftundurchlässige Verstärkungsschicht umfasst, die zwischen der Tintenaufnahmeschicht und der druckempfindlichen Klebeschicht angeordnet ist, wobei sich das Luftdurchlassloch von einer zur anderen Seite der luftundurchlässigen Verstärkungsschicht erstreckt.

5. Etikett nach Anspruch 1, das des Weiteren eine Oberflächenüberzugsschicht umfasst, die auf der Tintenaufnahmeschicht an der der druckempfindlichen Klebeschicht gegenüberliegenden Seite ausgebildet ist.

6. Etikett nach Anspruch 2, das des Weiteren eine Oberflächenüberzugsschicht umfasst, die auf der Tintenaufnahmeschicht an der der druckempfindlichen Klebeschicht gegenüberliegenden Seite ausgebildet ist.

7. Etikett nach Anspruch 3, das des Weiteren eine Oberflächenüberzugsschicht umfasst, die auf der Tintenaufnahmeschicht an der der druckempfindlichen Klebeschicht gegenüberliegenden Seite ausgebildet ist.

8. Etikett nach Anspruch 4, das des Weiteren eine Oberflächenüberzugsschicht umfasst, die auf der Tintenaufnahmeschicht an der der druckempfindlichen Klebeschicht gegenüberliegenden Seite ausgebildet ist.

9. Etikett nach Anspruch 1, wobei die Polyolefine Polyethylen mit ultrahohem Molekulargewicht umfassen.

10. Etikett nach Anspruch 1, wobei die Tintenaufnahmeschicht Informationen trägt, die in einem Gebiet aufgedruckt sind, das sich außerhalb des Bereiches befindet, der von einem Gas durchdrungen wird, das durch das Luftdurchlassloch in der Tintenaufnahmeschicht hindurchgetreten ist.

11. Belüftungsgehäuse, das ein Gehäuse mit einer Öffnung und ein Etikett umfasst, das eine Tintenaufnahmeschicht und eine druckempfindliche Klebeschicht zum Aufbringen der Tintenaufnahmeschicht auf einen Träger umfasst, wobei die Tintenaufnahmeschicht ein luftdurchlässiges poröses Material ist, das wenigstens ein Harz umfasst, das aus Polytetrafluorethylen und Polyolefinen ausgewählt wird, und wenigstens in der druckempfindlichen Klebeschicht des Etiketts ein Luftdurchlassloch ausgebildet ist, das sich von einer zur anderen Seite der druckempfindlichen Klebeschicht in der Dickenrichtung erstreckt und ein Gas, das die Tintenaufnahmeschicht durchdrungen hat, hindurchtreten lässt, wobei das Etikett so auf das Gehäuse aufgebracht ist, dass das Luftdurchlassloch mit der Öffnung des Gehäuses verbunden ist.

## Revendications

1. Etiquette comprenant une couche de réception d'encre et une couche adhésive sensible à la pression pour appliquer la couche de réception d'encre à un support, dans laquelle la couche de réception d'encre est un matériau poreux perméable à l'air comprenant au moins une résine sélectionnée parmi le polytétrafluoroéthylène et les polyoléfines, et l'étiquette comporte, formé dans au moins la couche adhésive sensible à la pression, un trou de passage d'air qui s'étend d'un côté à l'autre de la couche adhésive sensible à la pression dans la direction de l'épaisseur et permet à un gaz qui s'est infiltré dans la couche de réception d'encre de passer à travers celui-ci.

2. Etiquette selon la revendication 1, comprenant en outre une couche de support perméable à l'air disposée entre la couche de réception d'encre et la couche adhésive sensible à la pression.

3. Etiquette selon la revendication 1, comprenant en outre une couche de renforcement imperméable à l'air disposée entre la couche de réception d'encre et la couche adhésive sensible à la pression, dans laquelle le trou de passage d'air s'étend d'un côté à l'autre de la couche de renforcement imperméable à l'air. '

4. Etiquette selon la revendication 2, comprenant en outre une couche de renforcement imperméable à l'air disposée entre la couche de réception d'encre et la couche adhésive sensible à la pression, dans laquelle le trou de passage d'air s'étend d'un côté à l'autre de la couche de renforcement imperméable à l'air.

5. Etiquette selon la revendication 1, comprenant en outre une couche de revêtement de surface formée sur la couche de réception d'encre sur le côté opposé à la couche adhésive sensible à la pression.

6. Etiquette selon la revendication 2, comprenant en outre une couche de revêtement de surface formée sur la couche de réception d'encre sur le côté opposé à la couche adhésive sensible à la pression.

7. Etiquette selon la revendication 3, comprenant en outre une couche de revêtement de surface formée sur la couche de réception d'encre sur le côté opposé à la couche adhésive sensible à la pression.

8. Etiquette selon la revendication 4, comprenant en outre une couche de revêtement de surface formée sur la couche de réception d'encre sur le côté opposé à la couche adhésive sensible à la pression.

9. Etiquette selon la revendication 1, dans laquelle les polyoléfines comprennent du polyéthylène à poids moléculaire ultra-léger.

10. Etiquette selon la revendication 1, dans laquelle la couche de réception d'encre porte des informations imprimées dans une zone située à l'extérieur de la région devant être infiltrée par un gaz qui est passé à travers le trou de passage d'air formé dans la couche de réception d'encre. '

11. Boîtier de ventilation comprenant un boîtier comportant une ouverture et une étiquette comprenant une couche de réception d'encre et une couche adhésive sensible à la pression pour appliquer la couche de réception d'encre à un support, dans laquelle la couche de réception d'encre est un matériau poreux perméable à l'air comprenant au moins une résine sélectionnée parmi le polytétrafluoroéthylène et les polyoléfines, et l'étiquette comporte, formé dans au moins la couche adhésive sensible à la pression, un trou de passage d'air qui s'étend d'un côté à l'autre de la couche adhésive sensible à la pression dans la direction de l'épaisseur et permet à un gaz qui s'est infiltré dans la couche de réception d'encre de passer à travers celui-ci, l'étiquette étant appliquée au boîtier de sorte que le trou de passage d'air soit relié à l'ouverture du boîtier.
